# EUROPÄISCHE PATENTSCHRIFT

(11) **EP 2 814 178 B1**
(45) Veröffentlichungstag und Bekanntmachung des Hinweises auf die Patenterteilung: **16.03.2016**
(21) Anmeldenummer: 13171344.8
(22) Anmeldetag: 11.06.2013
(51) Int. Cl.: H03M 1/00

(54) **Analogeingabebaugruppe**
Analog input assembly
Module de saisie analogique

(43) Veröffentlichungstag der Anmeldung: 17.12.2014
(73) Patentinhaber: Siemens Aktiengesellschaft, 80333 München (DE)
(72) Erfinder: Nötzold, Thomas, 09337 Bernsdorf (DE)

(56) Entgegenhaltungen:
- EP-A2- 0 660 089
- CN-U- 202 153 236
- JP-A- 2007 333 544

## Beschreibung

Die Erfindung betrifft eine Analogeingabebaugruppe umfassend eine Ansteuereinheit, einen Analog/Digital-Wandler, eine Eingangsschaltung mit einem ersten Eingang und einem zweiten Eingang, einen Spannungsteiler, welcher zwischen dem ersten Eingang und dem zweiten Eingang angeordnet ist, wobei die Ansteuereinheit mit dem ersten und zweiten Eingang verbunden ist und dem Analog/Digital-Wandler vorgeschaltet ist.

In der industriellen Automatisierungstechnik werden beispielsweise Analogeingabebaugruppen zur Messung von Prozessgrößen eingesetzt. An die Analogeingabebaugruppen werden Messumformer angeschlossen. Ein Anwendungsfall der Analogeingabebaugruppe mit angeschlossenen Messumformern ist die Umwandlung von den genannten Prozessgrößen in genormte Strombereiche. Die Messumformer lassen sich u.a. in einen Zweileiter-Messumformer oder einen Vierleiter-Messumformer in ihrer Anschlussart unterscheiden. Ein Zweileiter-Messumformer wird direkt über eine Versorgungsspannung in eine Stromschleife zu der Analogeingabebaugruppe eingesetzt. Die durch den Zweileiter-Messumformer umgeformte Prozessgröße wird dabei sozusagen in dem Versorgungsstrom des Zweileiter-Messumformers abgebildet. Wie der Name Zweileiter-Messumformers sagt, werden nur zwei Drähte für den Anschluss benötigt. Das Messsystem, also die Analogeingabebaugruppe, ist aufgrund des direkten Bezuges des Zweileiter-Messumformers zur Versorgungsspannung elektrisch auf einen Bezugspunkt beispielsweise Masse, bezogen.

Im Gegensatz dazu wird ein Vierleiter-Messumformer stets mit einer separaten Versorgungsspannung gespeist. Die eigentliche Stromschleife für die gewandelte Prozessgröße wird getrennt zur Versorgungsspannung angeschlossen. Daher werden insgesamt vier Drähte (zweimal Versorgungsspannung und zweimal Stromschleife des Messsignals) für den Anschluss an eine Analogeingabebaugruppe benötigt. Das Messsystem, also die Analogeingabebaugruppe, ist aufgrund der separaten Stromschleife bei dem Vierleiter-Messumformer meist galvanisch getrennt zur Versorgungsspannung, nicht elektrisch auf Masse bezogen.

Zunehmend werden Zweileiter-Messumformer eingesetzt, bei welchen ein Ausgangssignal im Bereich zwischen 4 und 20 mA liegt. Ein Vierleiter-Messumformer gibt ein Ausgangssignal im Bereich von 0 bis 20 mA ab.

Aus der DE 44 26 765 C1 ist bereits eine Schaltungsanordnung zur Anpassung eines Zweileiter-Messumformers an ein Vierleiter-Messsystem bekannt.

EP 0660089 beschreibt eine Sensorschnittstelle zur Bestimmung, ob ein zwei drahtiger oder ein dreidrahtiger Sensor mit der Sensorschnittstelle verbunden ist.

Aufgabe der Erfindung ist es, eine Analogeingabebaugruppe bereitzustellen, welche ohne zusätzliche Umschaltmittel einen Anschluss eines Zweileiter-Messumformers und einen Anschluss eines Vierleiter-Messumformers ermöglicht. Weiterhin ist es Aufgabe der Erfindung für die aus DE 44 26 765 C1 bekannte Schaltungsanordnung eine Alternative bereitzustellen, welche mit einem kleineren Schaltungsaufwand auskommt.

Die Aufgabe wird durch eine Analogeingabebaugruppe umfassend eine Ansteuereinheit, einen Analog/Digital-Wandler, eine Eingangsschaltung mit einem ersten Eingang und einem zweiten Eingang, einen Spannungsteiler, welcher zwischen dem ersten Eingang und dem zweiten Eingang angeordnet ist, wobei die Ansteuereinheit mit dem ersten und zweiten Eingang verbunden ist und dem Analog/Digital-Wandler vorgeschaltet ist, dadurch gelöst, dass der Spannungsteiler einen Mittenabgriff aufweist, welcher mit einem ersten Vergleichseingang eines Vergleichsmittels einer Regeleinheit verbunden ist, wobei die Regeleinheit ein Schaltmittel aufweist, welches zwischen dem zweiten Eingang und einem Bezugspunkt angeordnet ist, dass Vergleichsmittel ist mit einem zweiten Vergleichseingang ausgestaltet, welcher an eine Referenzquelle angeschlossen ist, dabei weist das Vergleichsmittel einen Steuerausgang auf, welcher mit einem Steuereingang des Schaltmittels verbunden ist, dabei ist die Regeleinheit derart ausgestaltet, dass das Schaltmittel bei Anschluss eines Zweileiter-Messumformers an den ersten Eingang, wobei der zweite Eingang unbeschaltet bleibt, einen Strompfad zu den Bezugspunkt freischaltet und bei Anschluss eines Vierleiter-Messumformers an dem ersten Eingang und dem zweiten Eingang, den Strompfad zu dem Bezugspunkt sperrt. Nach dem Stand der Technik wurde bisher entweder eine aufwändige Schaltungsanordnung nach DE 44 26 765 C1 oder separate Eingangsschaltungen für Zwei- und Vierdrahtanschlüsse in der Strommessung genutzt. Falls eine gemeinsame Eingangsschaltung für beide Arten der Messumformer genutzt wurde, musste für die Umschaltung der beiden Anschlussarten ein geeignetes Schaltelement in der Messbaugruppe eingesetzt und angesteuert werden. Andere Analogeingabebaugruppen oder Messbaugruppen erforderten wiederum zudem eine externe Kabelbrücke an den Messeingängen. Durch die erfindungsgemäße Analogeingabebaugruppe werden diese Nachteile nun umgangen. Mit der Erfindung wurde die Analogeingabebaugruppe derart erweitert, dass ein massefrei differenziell aufgebauter Messeingang der Eingangsschaltung für den Anschluss eines Vierleiter-Messumformers durch die Regeleinheit derart erweitert wurde, dass dieser auch für den Anschluss eines Zweileiter-Messumformers geeignet ist. Dabei wird der Spannungsteiler in einem geforderten Arbeitspunkt gehalten und gleichzeitig wird ein Strompfad zu dem Bezugspunkt, welcher eine Rückführung des Stromes zu einer Versorgungsmasse realisiert, ermöglicht, ohne die Notwendigkeit eines zusätzlichen Schaltelementes in der Analogeingabebaugruppe.

In einer vorteilhaften Ausgestaltung weist der Spannungsteiler einen ersten Widerstand und einen zweiten Widerstand in einer Reihenschaltung auf, wobei der Mittenabgriff zwischen dem ersten und dem zweiten Widerstand angeordnet ist. Vorzugsweise ist der Spannungsteiler mit seinem ersten Widerstand und seinem zweiten Widerstand symmetrisch aufgebaut, welches bedeutet, dass die Widerstandswerte annähernd gleich sind. Damit erhält man eine symmetrisch aufgebaute Eingangsschaltung für den Anschluss eines Vierleiter-Messumformers, welcher auch beliebig für den Anschluss eines Zweileiter-Messumformers genutzt werden kann.

Eine weitere vorteilhafte Ausgestaltung sieht vor, dass das Vergleichsmittel als ein Operationsverstärker und das Schaltmittel als ein Halbeiterschaltmittel, insbesondere als ein Transistor, ausgestaltet ist.

Zusammenfassend kann gesagt werden, dass die erfindungsgemäße Analogeingabebaugruppe nun über eine Eingangsschaltung verfügt, welche eine gemeinsame Nutzung eines Zweileiter-Messumformers oder eines Vierleiter-Messumformers durch die differenziell aufgebaute Eingangsschaltung ermöglicht, ohne dass ein zusätzliches Schaltsignal oder ein Schaltelement für die Umschaltung zwischen den beiden Betriebsarten genutzt werden muss. Es steht nun ein differenziell aufgebauter Messeingang für den Anschluss eines Vierleiter-Messumformers zur Verfügung, welcher durch die Regeleinheit derart erweitert wurde, dass dieser auch für den Anschluss eines Zweileiter-Messumformers geeignet ist.

Ein Ausführungsbeispiel wird in der Zeichnung näher beschrieben. Es zeigt die
- FIG 1: eine Analogeingabebaugruppe mit einem angeschlossenen Zweileiter-Messumformer und
- FIG 2: die Analogeingabebaugruppe mit einem angeschlossenen Vierleiter-Messumformer.

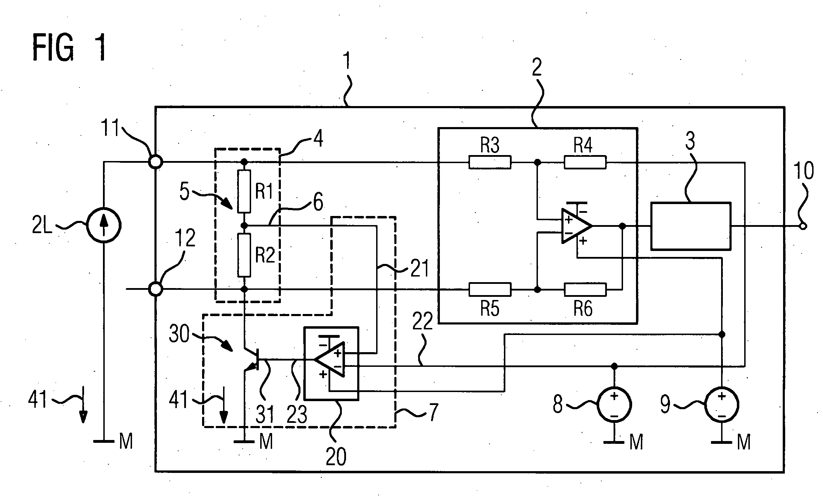

Gemäß FIG 1 ist eine Analogeingabebaugruppe 1 umfassend eine Ansteuereinheit 2, einen Analog/Digital-Wandler 3, eine Eingangsschaltung 4 mit einem ersten Eingang 11 und einem zweiten Eingang 12, einen Spannungsteiler 5, welcher zwischen dem ersten Eingang 11 und dem zweiten Eingang 12 angeordnet ist, dargestellt. Die Ansteuereinheit 2 ist mit dem ersten und zweiten Eingang 11,12 verbunden und dem Analog/Digital-Wandler 3 vorgeschaltet. Ein über den Spannungsteiler 5 abfallendes Spannungssignal wird von der Ansteuereinheit 2 ausgewertet und dem Analog/Digital-Wandler 3 zugeführt, welcher dann über einen Digitalausgang 10 das umgewandelte Digitalsignal für eine weitere Verarbeitung bereitstellt.

Mit der Kombination aus der Eingangsschaltung 4 und aus einer Regeleinheit 7 ist in der Analogeingabebaugruppe 1 nun eine kombinierte Eingangsschaltung 4 ohne eine bedingte Umschaltung für den Zweileiter-Messumformeranschluss oder den Vierleiter-Messumformeranschluss zur Strommessung realisiert. Dazu weist der Spannungsteiler 5 einen Mittenabgriff 6 auf, welcher mit einem ersten Vergleichseingang 21 eines Vergleichsmittels 20 der Regeleinheit 7 verbunden ist, wobei die Regeleinheit 7 ein Schaltmittel 30 aufweist, welches zwischen dem zweiten Eingang 12 und einem Bezugspunkt M angeordnet ist, das Vergleichsmittel 20 ist mit einem zweiten Vergleichseingang 22 ausgestaltet, welcher an eine Referenzquelle 8 angeschlossen ist, dabei weist das Vergleichsmittel 20 einen Steuerausgang 23 auf, welcher mit einem Steuereingang 31 des Schaltmittels 30 verbunden ist.

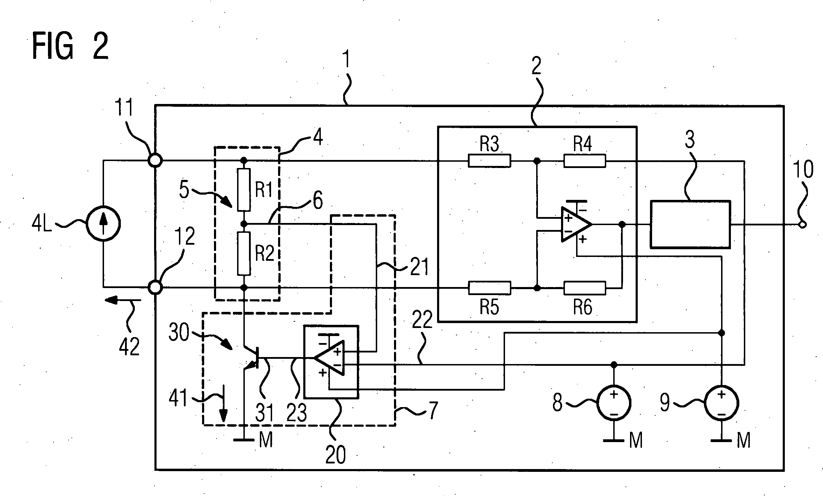

Wird wie in FIG 1 gezeigt, an die Analogeingabebaugruppe 1 ein Zweileiter-Messumformer 2L angeschlossen, wird dieser Zweileiter-Messumformer 2L mit seinem ersten Leiter an dem ersten Eingang 11 und mit seinem zweiten Leiter an einem Bezugspunkt M angeschlossen. Der Bezugspunkt M symbolisiert in diesem Fall eine gemeinsame Masse des Zweileiter-Messumformers 2L und der Analogeingabebaugruppe 1. Durch die Integration des Mittenabgriffes 6 in die Eingangsschaltung 4, wobei der Mittenabgriff 6 der Regeleinheit 7 eine Regelgröße zur Verfügung stellt, ist es nun möglich, ohne weitere Schaltungsmaßnahmen an der Analogeingabebaugruppe 1 entweder einen Zweileiter-Messumformer 2L zur Messung einer Prozessgröße an den ersten Eingang 11 anzuschließen oder einen Vierleiter-Messumformer 4L (siehe FIG 2) an den ersten Eingang 11 und den zweiten Eingang 12 anzuschließen.

Dabei ist die Regeleinheit 7 mit seinem Vergleichsmittel 20 und dem Schaltmittel 30 derart ausgestaltet, dass das Schaltmittel 30 bei Anschluss des Zweileiter-Messumformers 2L an den ersten Eingang 11, wobei der zweite Eingang 12 unbeschaltet bleibt, einen Strompfad 41 zu dem Bezugspunkt M freizuschalten und bei Anschluss eines Vierleiter-Messumformers 4L an den ersten Eingang 11 und dem zweiten Eingang 12, den Strompfad 41 zu den Bezugspunkt zu sperren, aber gleichzeitig einen weiteren zweiten Strompfad 42 zurück zu den Vierleiter-Messumformer 4L über den zweiten Eingang 12 zu ermöglichen.

Das Vergleichsmittel 20 ist als ein Operationsverstärker mit einem ersten Vergleichseingang 21 und einem zweiten Vergleichseingang 22 und einem Steuerausgang 23 aufgebaut. Der erste Vergleichseingang 21 ist mit dem Mittenabgriff 6 und der zweite Vergleichseingang 22 ist mit dem Pluspol einer Referenzquelle 8 verbunden. Über die Referenzquelle 8 wird beispielsweise eine positive Spannung von 2,5 V bereitgestellt.

Das Schaltmittel 30 ist als ein NPN-Transistor ausgestaltet, wobei der Emitter mit dem Bezugspunkt M verbunden ist und der Kollektor in Verbindung mit einem Knotenpunkt steht, an welchem der zweite Eingang 12 und ein Ende der Messbrücke 6 angeschlossen ist.

Die Ansteuereinheit 2 für den Analog/Digital-Wandler 3 weist einen weiteren Operationsverstärker mit zur Anschaltung des Operationsverstärkers notwendigen Widerständen R3,R4,R5 und R6 auf. Eine Versorgungsquelle 9 versorgt die beiden Operationsverstärker mit einer Versorgungsspannung.

Gemäß FIG 2 ist an die Analogeingabebaugruppe 1 ein Vierleiter-Messumformer 4L an den ersten Eingang 11 und den zweiten Eingang 12 angeschlossen. Der Vierleiter-Messumformer 4L ist in Form einer Stromquelle gezeichnet. Für die Anschlussart des Vierleiter-Messumformers 4L entsteht ein zweiter Strompfad 42 zwischen dem ersten Eingang 11, dem ersten Widerstand R1 und dem zweiten Widerstand R2 und dem zweiten Eingang 12.

Zwischen dem ersten Widerstand R1 und dem zweiten Widerstand R2 stellt sich bedingt durch die Ansteuerschaltung 2 ein Arbeitspunkt mit dem Potential der Referenzspannung der Referenzquelle 8 ein. Da der eingeprägte Strom keinen Bezug zu einer elektrischen Masse der Eingangsschaltung hat, muss der eingeprägte Strom die Eingangsschaltung über den zweiten Eingang 12 verlassen. Also wird das Schaltmittel 20 über den Operationsverstärker des Vergleichsmittels 20 derart angesteuert, dass das Schaltmittel 30 sperrt.

Wird die Eingangsschaltung 4 mit einem Zweileiter-Messumformer 2L beschaltet, ist der zweite Eingang 12 unbeschaltet und eine Stromschleife bzw. der Strompfad 41 wird über den Bezugspunkt M, also die elektrische Masse, zur elektrischen Masse des Zweileiter-Messumformers 2L geschlossen. Um die Eingangsschaltung 4 bzw. der Spannungsteiler 5 mit seinem Mittenabgriff 6 in seinem geforderten Arbeitspunkt (Referenzspannung zwischen dem ersten Widerstand R1 und dem zweiten Widerstand R2) zu halten, steuert das Vergleichsmittel 20 über seinen Steuerausgang 23 das Schaltmittel 30 derart an, dass dessen Ausgangswiderstand den erforderlichen Spannungsabfall erzeugt. Die eingebrachte Regeleinheit 7, aufweisend einen Operationsverstärker und einen Transistor, besitzt folgende Vorteile:
1. Die symmetrisch aufgebaute Eingangsschaltung 4 für den Anschluss eines Vierleiter-Messumformers kann ohne Einschränkung für den Anschluss eines Zweileiter-Messumformers genutzt werden.
2. Es sind keine weiteren zusätzlichen Schaltungselemente für die Umschaltung zwischen den beiden Anschlussarten notwendig.
3. Da keine Schaltungselemente für die Umschaltung notwendig sind, werden auch keine zusätzlichen Ansteuersignale benötigt.

Zusätzliche Schaltungselemente sind gerade bei Analogeingabebaugruppen mit galvanischer Trennung zwischen Steuerung und Messeingang nicht nur platzaufwändig, sondern auch recht kostenintensiv. Zudem wird eine Firmware-Struktur für eine Analogeingabebaugruppe durch den erfindungsgemäßen kombinierten Eingang vereinfacht.

## Patentansprüche

1. Analogeingabebaugruppe (1) umfassend
eine Ansteuereinheit (2),
einen Analog/Digital-Wandler (3),
eine Eingangsschaltung (4) mit einem ersten Eingang (11) und einem zweiten Eingang (12),
einen Spannungsteiler (5), welcher zwischen dem ersten Eingang (11) und dem zweiten Eingang (12) angeordnet ist, wobei die Ansteuereinheit (2) mit dem ersten und zweiten Eingang (11,12) verbunden ist und dem Analog/Digital-Wandler (3) vorgeschaltet ist,
wobei
der Spannungsteiler (5) einen Mittenabgriff (6) aufweist, welcher mit einem ersten Vergleichseingang (21) eines Vergleichsmittels (20) einer Regeleinheit (7) verbunden ist, wobei die Regeleinheit (7) ein Schaltmittel (30) aufweist, welches zwischen dem zweiten Eingang (12) und einem Bezugspunkt (M) angeordnet ist, das Vergleichsmittel (20) ist mit einem zweiten Vergleichseingang (22) ausgestaltet, welcher an eine Referenzquelle (8) angeschlossen ist, dabei weist das Vergleichsmittel (20) einen Steuerausgang (23) auf, welcher mit einem Steuereingang (31) des Schaltmittels (30) verbunden ist, dabei ist die Regeleinheit (7) derart ausgestaltet, dass das Schaltmittel (30) bei Anschluss
• eines Zweileiter-Messumformers (2L) an den ersten Eingang (11), wobei der zweite Eingang (12) unbeschaltet bleibt, einen Strompfad (41) zu dem Bezugspunkt (M) freischaltet und bei Anschluss
• eines Vierleiter-Messumformers (4L) an den ersten Eingang (11) und den zweiten Eingang (12), den Strompfad (41) zu dem Bezugspunkt (M) sperrt.

2. Analogeingabebaugruppe (1) nach Anspruch 1, wobei der Spannungsteiler (5) einen ersten Widerstand (R1) und einen zweiten Widerstand (R2) in einer Reihenschaltung aufweist, wobei der Mittenabgriff (6) zwischen dem ersten und zweiten Widerstand (R1,R2) angeordnet ist.

3. Analogeingabebaugruppe (1) nach Anspruch 1 oder 2, wobei das Vergleichsmittel (20) als ein Operationsverstärker und das Schaltmittel (30) als ein Halbleiterschaltmittel ausgestaltet ist.

## Claims

1. Analogue input module (1) comprising
an activation unit (2),
an analogue/digital converter (3),
an input circuit (4) with a first input (11) and a second input (12),
a voltage divider (5), which is disposed between the first input (11) and the second input (12), wherein the activation unit (2) is connected to the first input and the second input (11, 12) and is connected upstream of the analogue/digital converter,
wherein the voltage divider (5) has centre tap (6) which is connected to a first comparator input (21) of a comparator means (20) of a closed-loop control unit (7), wherein the closed-loop control unit (7) has switching means (30) which is disposed between the second input (12) and a reference point (M), the comparator means (20) is embodied with a second comparator input (22) which is connected to a reference source (8), in this case the comparator means (20) has a control output (23) which is connected to a control input (31) of the switching means (30), in this case the closed-loop control unit (7) is embodied such that the switching means (30),
• on connection of a two-wire transducer (2L) to the first input (11), wherein the second input (12) remains unconnected, enables a current path (41) to the reference point (M) and
• on connection of a four-wire transducer (4L) to the first input (11) and the second input (12), disables the current path (41) to the reference point (M).

2. Analogue input module (1) according to claim 1, wherein the voltage divider (5) has a first resistor (R1) and a second resistor (R2) in a series circuit, wherein the centre tap (6) is disposed between the first and the second resistor (R1, R2).

3. Analogue input module (1) according to claim 1 or 2, wherein the comparator means (20) is embodied as an operational amplifier and the switching means (30) is embodied as a semiconductor switching means.

## Revendications

1. Module ( 1 ) de saisie analogique comprenant une unité ( 2 ) de commande,
un convertisseur ( 3 ) analogique/numérique,
un circuit ( 4 ) d'entrée ayant une première entrée ( 11 ) et une deuxième entrée ( 12 ),
un diviseur ( 5 ) de tension, qui est monté entre la première entrée ( 11 ) et la deuxième entrée ( 12 ), l'unité ( 2 ) de commande étant reliée à la première et à la deuxième entrées ( 11, 12 ) et étant montée en amont du convertisseur ( 3 ) analogique/numérique,
dans lequel
le diviseur ( 5 ) de tension a une prise ( 6 ) médiane, qui est reliée à une première entrée ( 21 ) de comparaison d'un moyen ( 20 ) de comparaison d'une unité ( 7 ) de régulation, l'unité ( 7 ) de régulation ayant un moyen ( 30 ) de commutation, qui est monté entre la deuxième entrée ( 12 ) et un point ( M ) de référence, le moyen ( 20 ) de comparaison est conformé en ayant une deuxième entrée ( 22 ) de comparaison, qui est raccordée à une source ( 8 ) de référence, le moyen ( 20 ) de comparaison a une sortie ( 23 ) de commande, qui est reliée à une entrée ( 31 ) de commande du moyen ( 30 ) de commutation, l'unité ( 7 ) de régulation est conformée de manière à ce que le moyen ( 30 ) de commutation, à la connexion
d'un transducteur ( 2L ) de mesure bifilaire à la première entrée ( 11 ), la deuxième entrée ( 12 ) restant non connectée, libère un trajet ( 41 ) de courant vers le point ( M ) de référence et, à la connexion
d'un transducteur ( 4L ) de mesure quadrifilaire à la première entrée ( 11 ) et à la deuxième entrée ( 12 ), bloque le trajet ( 41 ) de courant vers le point ( M ) de référence.

2. Module ( 1 ) de saisie analogique suivant la revendication 1, dans lequel le diviseur ( 5 ) de tension a une première résistance ( R1 ) et une deuxième résistance ( R2 ) suivant un montage en série, la prise ( 6 ) médiane étant disposée entre la première et la deuxième résistances ( R1, R2 ).

3. Module ( 1 ) suivant la revendication 1 ou 2, dans lequel le moyen ( 20 ) de comparaison est conformé en amplificateur opérationnel et le moyen ( 30 ) de commutation en moyen de commutation à semi-conducteur.
